# FASCICULE DE BREVET EUROPEEN

(11) **EP 3 787 007 B1**
(45) Date de publication et mention de la délivrance du brevet: **09.10.2024**
(21) Numéro de dépôt: 20192014.7
(22) Date de dépôt: 20.08.2020
(51) Int. Cl.: H01L 21/285, H01L 31/0224, H01L 31/105, H01L 31/18

(54) **PRISE DE CONTACT SUR DU GERMANIUM**
KONTAKTANSCHLUSS AUF GERMANIUM
CONTACT ON GERMANIUM

(30) Priorité: 30.08.2019 FR 1909581
(43) Date de publication de la demande: 03.03.2021
(73) Titulaire: Commissariat à l'Energie Atomique et aux Energies Alternatives, 75015 Paris (FR)
(72) Inventeur: LUDURCZAK, Willy, 38054 GRENOBLE CEDEX 9 (FR); ALIANE, Abdelkader, 38054 GRENOBLE CEDEX 9 (FR); HARTMANN, Jean-Michel, 38054 GRENOBLE CEDEX 9 (FR); MEHREZ, Zouhir, 38054 GRENOBLE CEDEX 9 (FR); RODRIGUEZ, Philippe, 38054 GRENOBLE CEDEX 9 (FR)
(74) Mandataire: Cabinet Beaumont

(56) Documents cités:
- EP-A2- 2 333 820
- US-A1- 2007 148 966
- US-A1- 2008 171 408
- US-A1- 2017 213 889

## Description

### Domaine technique

La présente description concerne de façon générale les dispositifs électroniques, et plus particulièrement des composants électroniques comprenant du germanium et les procédés de fabrication de composants électroniques.

### Technique antérieure

Certains composants électroniques, tels que des transistors, des diodes, etc., utilisent les propriétés du germanium. Par exemple, une photodiode de type PIN, c'est-à-dire une photodiode comprenant une région semiconductrice intrinsèque entre des régions semiconductrices dopées de types N et P, peut-être basée sur du germanium. La photodiode peut alors détecter des rayonnements optiques de longueurs d'onde comprises entre 0,9 µm et 1,5 pm.

Dans un tel composant, une région comprenant du germanium est destinée à être connectée électriquement à d'autres dispositifs par une liaison conductrice. Le contact électrique entre cette région et la liaison conductrice est assuré par une zone de contact, ou prise de contact.

La prise de contact est typiquement située au fond d'une ouverture pratiquée dans une couche isolante. US2007148966 décrit une méthode de fabrication d'une interconnection sur substrat contenant du germanium.

### Résumé de l'invention

Il existe un besoin de réduire les résistances et/ou d'augmenter la fiabilité des prises de contact connues sur une région semiconductrice comprenant du germanium.

Il existe un besoin de simplifier les procédés connus de réalisation de prises de contact sur une région semiconductrice comprenant du germanium.

Un mode de réalisation pallie tout ou partie des inconvénients des prises de contact connues avec une région semiconductrice comprenant du germanium.

Un mode de réalisation pallie tout ou partie des inconvénients des procédés connus de réalisation de prise de contact avec une région semiconductrice comprenant du germanium.

Un mode de réalisation pallie tout ou partie des inconvénients des procédés de gravure d'une ouverture dans un isolant recouvrant une région semiconductrice comprenant du germanium.

Un mode de réalisation pallie tout ou partie des inconvénients des photodiodes connues de type PIN comprenant une région intrinsèque de germanium. En particulier, un mode de réalisation prévoit une photodiode présentant un courant d'obscurité réduit.

Ainsi, selon un premier aspect, un mode de réalisation prévoit un procédé de formation d'une prise de contact électrique avec une région semiconductrice constituée principalement de germanium selon la revendication 1.

Un mode de réalisation prévoit une photodiode formée par un procédé tel que défini ci-dessus.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, représentant une étape d'un premier mode de réalisation d'un procédé de fabrication d'une prise de contact ;
la figure 2 est une vue en coupe, partielle et schématique, représentant une autre étape du premier mode de réalisation ;
la figure 3 est une vue en coupe, partielle et schématique, représentant une autre étape du premier mode de réalisation ;
la figure 4 est une vue en coupe, partielle et schématique, représentant une autre étape du premier mode de réalisation ;
la figure 5 est une vue en coupe, partielle et schématique, représentant une étape d'un deuxième mode de réalisation d'un procédé de fabrication d'une prise de contact ;
la figure 6 est une vue en coupe, partielle et schématique, représentant une autre étape du deuxième mode de réalisation ;
la figure 7 est une vue en coupe, partielle et schématique, représentant une autre étape du deuxième mode de réalisation ;
la figure 8 est une vue en coupe, partielle et schématique, représentant une étape d'un troisième mode de réalisation d'un procédé de fabrication d'une prise de contact ;
la figure 9 est une vue en coupe, partielle et schématique, représentant une autre étape du troisième mode de réalisation ;
la figure 10 est une vue en coupe, partielle et schématique, représentant une autre étape du troisième mode de réalisation ;
la figure 11 est une vue en coupe, partielle et schématique, représentant une étape d'un mode de mise en oeuvre, dans l'exemple du deuxième mode de réalisation, d'un procédé de formation d'une ouverture dans une couche isolante recouvrant une région semiconductrice comprenant du germanium ;
la figure 12 est une vue en coupe, partielle et schématique, représentant une autre étape du mode de mise en oeuvre du procédé de formation d'une ouverture ;
la figure 13 est une vue en coupe, partielle et schématique, représentant une autre étape du mode de mise en oeuvre du procédé de formation d'une ouverture ;
la figure 14 est une vue en coupe, partielle et schématique, représentant une autre étape du mode de mise en oeuvre du procédé de formation d'une ouverture ;
la figure 15 est une vue en coupe, partielle et schématique, représentant une autre étape du mode de mise en oeuvre du procédé de formation d'une ouverture ;
la figure 16 est une vue en coupe, partielle et schématique, représentant un quatrième mode de réalisation d'un procédé de fabrication d'une prise de contact, mettant en oeuvre les étapes des figures 11 à 15 ;
la figure 17 est une vue en coupe, partielle et schématique, représentant une variante de mise en oeuvre du procédé de formation d'une ouverture;
La figure 18 est une vue en coupe, partielle et schématique, représentant une étape d'une variante du quatrième mode de réalisation, mettant en oeuvre la variante de la figure 17 ;
La figure 19 est une vue en coupe, partielle et schématique, représentant une autre étape de la variante du quatrième mode de réalisation ;
la figure 20 est une vue en coupe, partielle et schématique, représentant un cinquième mode de réalisation d'un procédé de fabrication d'une prise de contact, mettant en oeuvre la variante de la figure 17 ;
la figure 21 est une vue en coupe, partielle et schématique, représentant un mode de réalisation d'une photodiode ;
la figure 22 est une vue en coupe, partielle et schématique, représentant un autre mode de réalisation d'une photodiode.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, dans les composants électroniques, les éléments autres qu'une région semiconductrice comprenant du germanium, une prise de contact, et un conducteur électrique, n'ont pas été décrits, les modes de réalisation étant compatibles avec les composants électroniques connus comportant une région en germanium.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

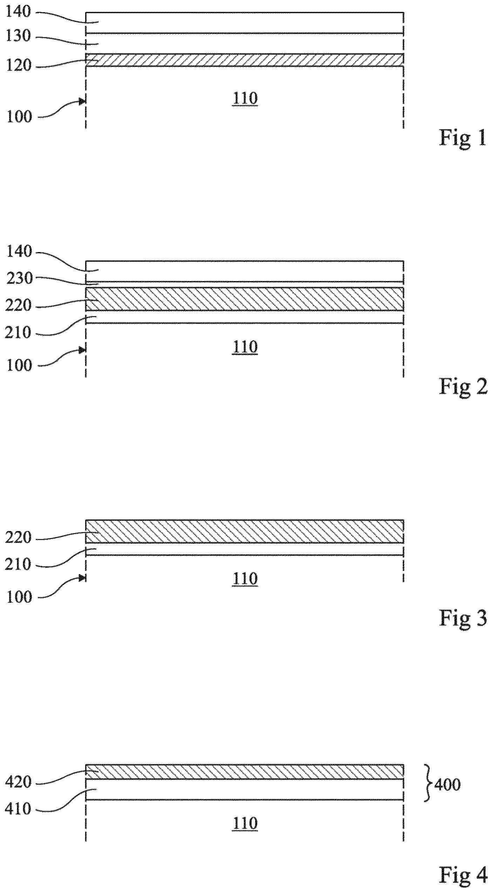

Les figures 1 à 4 sont des vues en coupe, partielles et schématiques, représentant des étapes d'un mode de réalisation d'un procédé de fabrication d'une prise de contact sur une région comprenant du germanium.

Le procédé est mis en oeuvre au cours de la fabrication d'un dispositif électronique comprenant un ou plusieurs composants comprenant du germanium ou à base de germanium. Le dispositif peut comprendre, ou être constitué par, une puce électronique de circuit intégré. Une telle puce est définie par une portion de tranche semiconductrice et des éléments, tels que des composants électroniques, intégralement situés dans et sur une face de la tranche. En particulier, le procédé peut être mis en oeuvre pour la fabrication d'une photodiode comprenant du germanium.

A l'étape de la figure 1, on prévoit un substrat 100. Le substrat 100 peut être constitué par une portion de tranche semiconductrice, par exemple en germanium. Le substrat 100 peut également être constitué par une couche recouvrant la face supérieure d'un support tel que, par exemple une tranche semiconductrice.

Une région semiconductrice 110 comprenant du germanium est située du côté d'une face du substrat 100, par exemple la face avant ou supérieure du substrat 100. Dans le cas où le substrat 100 comprend, ou est constitué par, du germanium, la région 110 est par exemple une région dopée du substrat. Dans le cas où le substrat 100 est en un autre semiconducteur que le germanium, par exemple en silicium, la région semiconductrice 110 peut avoir été formée par exemple dans une cavité gravée dans le substrat 100. De préférence, la région semiconductrice 110 est monocristalline, le substrat 100 étant de préférence monocristallin. La région semiconductrice 110 peut alors résulter d'une épitaxie.

La région 110 est constituée principalement, c'est-à-dire majoritairement, de germanium. Autrement dit, la région 110 est constituée d'un matériau semiconducteur présentant un pourcentage atomique de germanium supérieur à 50 %, de préférence supérieur à 90 %. Dans un exemple préféré, la région 110 est constituée de germanium, par exemple dopé. Plus préférentiellement, la région 110 est en germanium monocristallin. Dans un autre exemple, la région 110 est constituée de silicium-germanium, par exemple dopé.

On forme, sur la région semiconductrice 110, une couche semiconductrice 120 présentant un pourcentage atomique de silicium supérieur à 70 %. La couche 120 peut comprendre, outre le silicium, un métalloïde différent du silicium, préférentiellement du germanium. Dans un exemple préféré, la couche 120 est constituée de silicium. Dans un autre exemple, la couche 120 est constituée de silicium-germanium.

De préférence, la couche semiconductrice 120 est monocristalline. Pour cela, la couche 120 peut être obtenue par épitaxie sur la région 110 monocristalline. L'épaisseur de la couche semiconductrice 120 est inférieure à un seuil d'épaisseur permettant que la couche épitaxiée soit monocristalline. Ce seuil d'épaisseur peut être déterminé expérimentalement en fonction de la composition de la couche semiconductrice 120 et de la région semiconductrice 110. Ce seuil est de l'ordre de 2 nm pour une couche 120 de silicium épitaxiée sur la région 110 en germanium. En variante, la couche semiconductrice 120 n'est pas monocristalline. L'épaisseur de la couche 120 peut alors être supérieure au seuil d'épaisseur.

On forme ensuite une couche métallique 130 recouvrant la couche semiconductrice 120. De préférence, la couche métallique 130 comprend du nickel, par exemple est sensiblement constituée du nickel, par exemple est constituée de nickel. De préférence, la couche 130 comprend, outre le nickel, du platine et/ou du cobalt. Dans un exemple préféré, le métal de la couche 130 comprend, plus préférentiellement est constitué par, du nickel et du cobalt, le pourcentage atomique du cobalt étant compris entre 5 et 20 %. Dans un autre exemple préféré, le métal de la couche 130 comprend, plus préférentiellement est constitué par, du nickel et du platine, le pourcentage atomique du platine étant compris entre 5 et 15 %.

De préférence, l'épaisseur de la couche métallique 130 est supérieure à la moitié de celle de la couche semiconductrice 120. Plus préférentiellement, la couche métallique 130 a une épaisseur comprise entre 7 et 50 nm.

De préférence, avant le dépôt de la couche métallique 130, on a préalablement procédé à une préparation de la surface supérieure de la couche semiconductrice 120. L'étape de préparation de surface comprend par exemple un traitement en phase liquide à base d'acide fluorhydrique, puis un traitement par plasma. Le plasma peut être à base d'argon, ou, par exemple, de type connu sous le nom commercial Siconi^{™}. Le traitement par plasma et le dépôt de la couche métallique 130 sont alors effectués successivement sans rupture de vide. Ceci permet d'éviter la présence d'impuretés, telles que des oxydes, entre les couches semiconductrice 120 et métallique 130. De telles impuretés pourraient provenir d'une exposition à l'air après l'étape de dépôt de la couche 120, ou après l'étape de préparation de surface en phase liquide. Les couches semiconductrice 120 et métallique 130 sont donc directement en contact l'une sur l'autre.

De préférence, après la formation de la couche métallique 130, on forme une couche de protection 140 sur la couche 130. Cette couche est alors préférentiellement formée sans rupture de vide après le dépôt de la couche métallique 130. La couche 140 est destinée à protéger les structures situées sous la couche 140 contre l'oxydation au cours d'étapes ultérieures du procédé. De préférence, la couche de protection 140 est en nitrure de titane. En variante, la couche de protection 140 peut être omise.

A l'étape de la figure 2, on effectue un premier traitement thermique. Plus précisément, ce traitement thermique correspond à un recuit de la structure obtenue de la figure 1. Ce premier traitement thermique est effectué à une température permettant de faire réagir partiellement le métal de la couche métallique 130 avec le matériau de la couche semiconductrice 120. On obtient ainsi une couche 220 à la place de la couche 120. La température du premier traitement thermique est de préférence inférieure ou égale à 300°C, par exemple comprise entre 250°C et 300°C, ce qui permet une réaction partielle de la couche 130 comprenant du nickel avec le matériau de la couche semiconductrice 120.

De préférence, le premier traitement thermique est effectué en présence de diazote. Le diazote est de préférence à la pression atmosphérique ou à une pression supérieure de moins de 1 bar à la pression atmosphérique. La durée du premier traitement thermique est préférentiellement comprise entre 10 s et 120 s.

La couche 220 comprend, de préférence est constituée par, un matériau intermétallique, ou composé intermétallique, c'est-à-dire l'association d'un ou plusieurs éléments chimiques métalliques et d'un ou plusieurs éléments chimiques, typiquement métalloïdes, pouvant entrer dans la composition d'un semiconducteur. De préférence, le matériau intermétallique a une structure cristalline associant les éléments chimiques métalliques et non métalliques. Dans la couche 220, les éléments chimiques non métalliques sont sensiblement constitués par le matériau de la couche semiconductrice 120. Notamment, le fait que plus de 70 % des atomes de la couche semiconductrice 120 sont de silicium implique que plus de 70 % des atomes non métalliques de la couche 220 sont de silicium. Dans un exemple préféré, le matériau intermétallique de la couche 220 est un siliciure de nickel ou un siliciure comprenant du nickel. Dans un autre exemple préféré, le matériau intermétallique de la couche 220 est un germano-siliciure de nickel ou un germano-siliciure comprenant du nickel.

De préférence, l'épaisseur de la couche métallique 130 choisie à l'étape de la figure 1 est suffisante pour qu'une partie du métal de la couche 130 réagisse avec une partie supérieure de la région semiconductrice 110. Cette réaction produit une couche 210 située sous la couche 220. La couche 210 comprend, de préférence est constituée par, un matériau intermétallique. Du fait que la région 110 est principalement constituée de germanium, les atomes non métalliques de la couche 210 sont principalement des atomes de germanium. Ainsi, lorsque la couche métallique 130 est en nickel ou comprend du nickel, le matériau intermétallique de la couche 210 est en germaniure de nickel ou en un germaniure comprenant du nickel.

De préférence, l'épaisseur de la couche métallique 130 choisie à l'étape de la figure 1 est suffisante pour qu'une partie 230 de la couche métallique 130 ne réagisse pas avec la couche semiconductrice 120 et la région semiconductrice 110.

A l'étape de la figure 3, on retire l'éventuelle couche de protection 140, ainsi que la partie 230 de la couche 130 qui n'a pas réagi. Ce retrait est sélectif vis-à-vis du matériau de la couche 220. Le retrait est par exemple effectué dans une solution de gravure à base d'acide sulfurique et de peroxyde d'hydrogène, ou encore par exemple dans une solution de gravure à base d'acide chlorhydrique et d'acide nitrique. Du fait que la couche 220 comprenne, en dehors des éléments métalliques, plus de 70 % d'atomes de silicium, ces solutions permettent de graver les matériaux des couches 130 et 140 sans retirer ou altérer la couche 220.

A l'étape de la figure 4, on effectue un deuxième traitement thermique. Ce traitement thermique correspond à un recuit de la structure obtenue à l'étape de la figure 3. Ceci transforme les couches 210 et 220 en couches respectives 410 et 420.

Lorsque la couche 130 comprend du nickel, la température du traitement thermique est de préférence supérieure ou égale à 390°C. Ceci permet que, après le deuxième traitement thermique, la phase du matériau intermétallique de la couche 420 présente une résistivité électrique inférieure à celle des autres phases de cet intermétallique. Notamment, ceci permet que de la couche 420 comprenne le même proportion d'atomes métalliques que d'atomes non métalliques, par exemple comprenne les mêmes proportions atomiques de nickel et du silicium (NiSi). A titre d'exemple, une partie du nickel contenu dans la couche 220 à l'étape de la figure 3 réagit avec la région semiconductrice 110 pendant le deuxième recuit. L'épaisseur de la couche 410 est alors supérieure à celle de la couche 210 (figures 2 et 3). En variante, la couche 210 n'est pas formée au cours du premier traitement thermique, et seule la couche 410 est formée au cours du deuxième traitement thermique. Le fait, mentionné ci-dessus, qu'à l'étape de la figure 1 l'épaisseur de la couche métallique 130 est préférentiellement supérieure à la moitié de celle de la couche semiconductrice 120, permet d'obtenir la couche 410 au cours du deuxième traitement thermique.

En outre, lorsque la couche 130 comprend du nickel, la température de traitement thermique est de préférence inférieure à 420°C. Ceci permet d'optimiser la résistivité du germaniure de nickel de la couche 410, et d'éviter de détériorer cette résistivité par une température trop élevée.

Les zones intermétalliques définies par les couches 410 et 420 ainsi obtenues constituent une prise de contact électrique 400 sur la région semiconductrice 110.

On aurait pu penser former une prise de contact ne comprenant pas la couche 420. Pour cela, on aurait pu imaginer mettre en oeuvre des étapes similaires à celles des figures 1 à 4, mais sans former la couche 120 de silicium. Cependant, au cours d'une étape, telle que celle de la figure 3, de retrait de la partie d'une couche métallique n'ayant pas réagi, le contact entre le germanium et une solution de gravure aurait risqué d'oxyder le germanium et de dissoudre l'oxyde de germanium dans la solution. Ceci aurait endommagé la région semiconductrice 110. Il en aurait résulté des problèmes de fiabilité et de résistance de la prise de contact.

Ainsi, la présence de la couche 420 permet d'obtenir une prise de contact 400 sur le germanium ayant une résistivité et une fiabilité meilleures qu'une prise de contact dépourvue d'une telle couche.

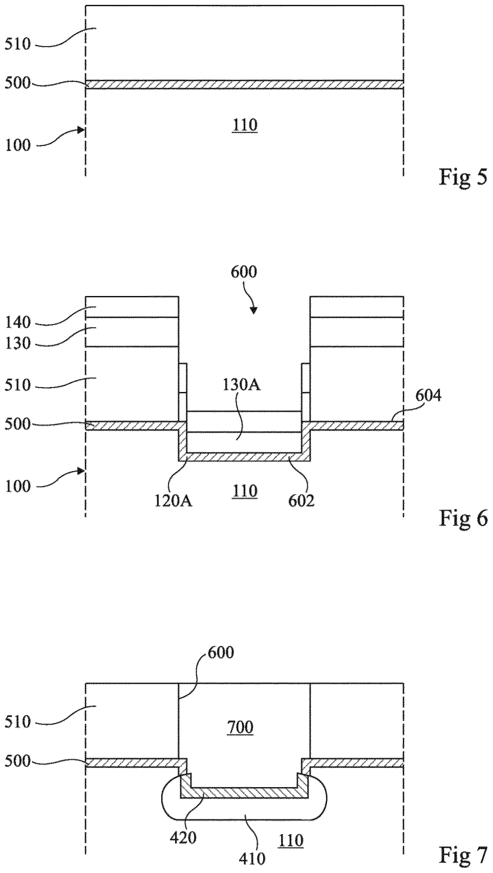

Les figures 5 à 7 sont des vues en coupe, partielles et schématiques, représentant des étapes d'un autre mode de réalisation d'un procédé de fabrication d'une prise de contact sur une région semiconductrice 110 comprenant du germanium. La région semiconductrice 110 est identique ou similaire à celle décrite en relation avec la figure 1, et est préférentiellement située en partie supérieure d'un substrat 100.

A l'étape de la figure 5, de préférence, on forme sur la surface supérieure de la région semiconductrice 110 une couche semiconductrice 500 comprenant du silicium. La couche 500 est constituée de silicium, ou présente un pourcentage atomique de silicium supérieur à 70 %. A titre d'exemple, on fait croître la couche 500 par épitaxie sur la surface de la région semiconductrice 110. L'épaisseur de la couche 500 est par exemple comprise entre 1 nm et 3 nm, de préférence de l'ordre de 2 nm.

On forme ensuite une couche électriquement isolante 510 sur la couche semiconductrice 500. La couche isolante 510 peut être en oxyde de silicium, de préférence en dioxyde de silicium, plus préférentiellement résultant d'une hydrolyse d'orthosilicate de tétraéthyle (TEOS). Dans un exemple, la couche isolante d'oxyde de silicium 510 est une couche de passivation. De préférence, l'épaisseur de la couche isolante 510 est de l'ordre de, ou supérieure à, 100 nm.

A l'étape de la figure 6, on grave une ouverture 600 traversant la couche isolante 510 de part en part à l'emplacement de la future prise de contact. De préférence, l'ouverture 600 est réalisée seulement au-dessus d'une partie de la région semiconductrice 110. La largeur de l'ouverture peut être comprise entre 300 nm et 1,5 um. L'ouverture 600 est compatible avec tout procédé usuel d'obtention d'une ouverture dans une couche isolante, par exemple une photolithographie suivie d'une gravure par plasma (le masque de gravure n'est pas représenté). En pratique, l'ouverture 600 est prolongée à travers la couche 500 jusqu'à un niveau situé dans la région semiconductrice 110. La différence de niveau, c'est-à-dire la distance dans la direction orthogonale à la face supérieure du substrat 100, entre le fond 602 de l'ouverture 600 et la face supérieure 604 de la couche semiconductrice 500, est par exemple comprise entre 5 nm et 30 nm, de préférence de l'ordre de 10 nm.

On fait ensuite croître une couche semiconductrice 120A par épitaxie. La couche 120A est identique par sa composition et son épaisseur à la couche semiconductrice 120 du procédé des figures 1 à 4. La couche semiconductrice 120A croît à partir du fond 602 et des parties des parois latérales de l'ouverture 600 situées en dessous du niveau supérieur 604 de la couche 500. Il en résulte que la région semiconductrice définie par la couche 120A forme, avec les portions restantes de la couche 500, une couche semiconductrice continue, c'est-à-dire dépourvue d'ouvertures, recouvrant la région semiconductrice 110, cette couche continue comprenant au moins 70 % de silicium.

Après cela, on forme successivement les couches métallique 130 et éventuellement de protection 140 décrites en relation avec la figure 1. Les couches 130 et 140 recouvrent le fond de l'ouverture 600 et les portions restantes de la couche isolante 510. De préférence, l'épaisseur totale des couches métallique 130 et de protection 140 est inférieure à celle de la couche isolante 510. Dans l'exemple représenté, les couches métallique 130 et de protection 140 sont formées par dépôt non conforme, c'est-à-dire que les matériaux de ces couches ne sont déposés que sur les surfaces tournées vers le haut. Du fait que l'épaisseur de la couche métallique 130 est inférieure à celle de la couche isolante 510, il résulte une région métallique 130A sans contact avec le reste de la couche 130, et située au fond de l'ouverture 600. L'étape décrite ici n'est pas limitative, et on peut utiliser tout procédé permettant de former une région métallique 130A sur une partie seulement de la région semiconductrice 110. En variante, les couches métallique 130 et/ou de protection 140 peuvent être formées par dépôt conforme.

A l'étape de la figure 7, on met en oeuvre les étapes des figures 2 à 4, à savoir, successivement, le premier traitement thermique, le retrait de l'éventuelle couche de protection 140 et des portions restantes de la couche métallique 130, et le second traitement thermique. Il en résulte, sur la région 110 constituée principalement de germanium, une prise de contact comprenant une zone intermétallique 420 formée à partir de la couche semiconductrice 120A. Parmi les atomes non métalliques de la zone 420, plus de 70 % sont des atomes de silicium. De préférence, comme pour la couche 420 de la figure 4, les atomes non métalliques de la zone 420 sont des atomes de silicium. Plus préférentiellement, la zone 420 comprend du siliciure de nickel.

De préférence, comme pour le procédé des figures 1 à 4, la couche métallique 130 est choisie suffisamment épaisse pour former, sous la zone 420, une zone intermétallique 410, dans laquelle les atomes non métalliques sont principalement du germanium. Plus préférentiellement, la zone 410 comprend, par exemple est constituée par, du germaniure de nickel.

Ensuite, on remplit l'ouverture 600 par un conducteur électrique 700. Le conducteur 700 permet d'établir une connexion électrique avec la région semiconductrice 110. Par exemple, le conducteur 700 peut être recouvert de, et en contact avec, une piste de liaison électrique entre composants d'une puce électronique.

Un avantage du procédé des figures 5 à 7 et que la prise de contact avec la région semiconductrice 110, constituée des zones 420 et 410, est auto-alignée avec le conducteur 700. Dans une puce électronique comprenant plusieurs prises de contact obtenues par le procédé des figures 5 à 7, ceci permet des prises de contact plus rapprochées que dans un dispositif dans lequel les prises de contact ne sont pas ainsi auto-alignées. On peut donc augmenter, c'est-à-dire améliorer, la densité des composants de la puce.

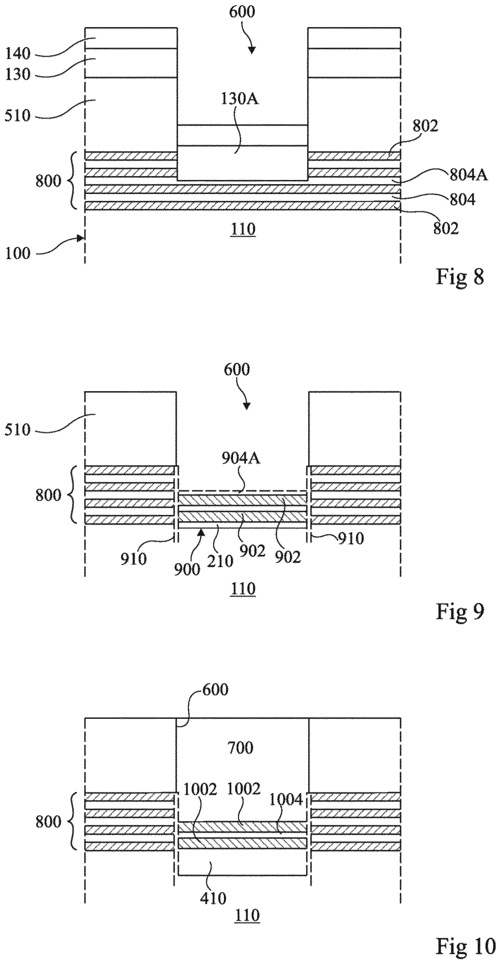

Les figures 8 à 10 sont des vues en coupe, partielles et schématiques, représentant des étapes d'un autre mode de réalisation d'un procédé de formation d'une zone de contact localisée sur une région semiconductrice 110 comprenant du germanium. La région semiconductrice 110 est identique à celle décrite en relation avec la figure 1. En particulier, la région semiconductrice 110 se trouve préférentiellement côté face avant d'un substrat 100.

A l'étape de la figure 8, on recouvre la région semiconductrice 110 d'un multicouches 800 comprenant, en alternance, des couches 802 de silicium et des couches 804 de germanium. Plus précisément, les couches 802 présentent une proportion atomique de silicium supérieure à 70 %. De préférence, les couches 802 sont en silicium, ou en silicium-germanium présentant une proportion atomique de silicium supérieure à 70 %. Les couches 804 sont en germanium ou sont constituées principalement de germanium. De préférence, les couches 804 sont en germanium, ou en silicium-germanium constitué principalement de germanium. A titre d'exemple, l'épaisseur du multicouches 800 est supérieure à 10 nm, préférentiellement de l'ordre de 15 nm. De préférence, les couches 802 ont la même épaisseur. De préférence, les couches 804 ont la même épaisseur. Plus préférentiellement, les couches 802 et 804 ont toutes la même épaisseur.

De préférence, le multicouches 800 est formé par épitaxie sur la surface supérieure de la région monocristalline 110. Chacune des couches 802 et 804 a alors une épaisseur inférieure à un seuil d'épaisseur en deçà duquel la couche reste monocristalline. En pratique, ce seuil, ou épaisseur critique, dépend de la composition des couches 802 et 804. A titre d'exemple, chacune des couches 802 et 804 a une épaisseur de l'ordre de, ou inférieure à, 2 nm. Ainsi, le multicouches 800 obtenu est monocristallin.

On met ensuite en oeuvre des étapes similaires à celles des figures 5 et 6, à savoir la formation successivement d'une couche isolante 510, d'une ouverture 600 traversant entièrement la couche isolante 510, d'une couche métallique 130, et d'une éventuelle couche de protection 140. En pratique, l'ouverture 600 se prolonge jusqu'à un niveau situé à l'intérieur du multicouches 800. Dans l'exemple représenté, le fond de l'ouverture 600 est situé dans une couche 804A parmi les couches 804 constituées principalement de germanium. Dans un autre exemple, le fond de l'ouverture 600 s'arrête à l'intérieur d'une des couches 802, ou à une interface entre une des couche 802 et une des couches 804. Au moins une des couches 802 comprenant au moins 70 % de silicium n'est pas atteinte par l'ouverture 600 et est donc laissée intacte. Dans l'exemple représenté, deux des couches 802 ne sont pas gravées.

A l'étape de la figure 9, on a mis en oeuvre successivement les étapes des figures 2 et 3, c'est-à-dire le premier traitement thermique, et le retrait de l'éventuelle couche de protection 140 et des restes de la couche métallique 130. De préférence, l'épaisseur de la couche métallique 130 déposée à l'étape de la figure 8 est choisie suffisante pour que chacune des couches 802 et 804, ainsi qu'une partie de la région semiconductrice 110, réagisse avec le métal de la couche métallique 130. La réaction de chacune des couches 802, 804 avec le matériau de la région métallique 130A produit une zone 902 sous l'ouverture 600. Les parties de la structure situées entre les zones 902 et le reste du multicouches 800, délimitées en figure par des pointillés 910, ne sont pas représentées.

De préférence, on retire également la couche 904A (représentée en pointillés), qui résulte de la réaction de la couche 804A avec le matériau de la couche métallique 130. Ce retrait est préférentiellement effectué avec la même solution de gravure que celle utilisée pour retirer les parties restantes de la région métallique 130A. Ceci est possible du fait que les atomes non métalliques de la zone 904A sont principalement des atomes de germanium. Ceci permet d'éviter de conserver la zone 904A qui aurait été endommagée par la solution de gravure. On rend ainsi accessible la face supérieure de la zone 902 qui se trouvait sous et en contact avec la zone 904A avant le retrait. Du fait que plus de 70 %, ou la totalité, des atomes non métalliques de la zone 902 sont de silicium, la solution de gravure laisse intacte la zone 902. La zone 902 n'est donc pas endommagée par la gravure. Ainsi, la région semiconductrice 110 est protégée de la solution de gravure par au moins une des zones 902.

A l'étape de la figure 10, on procède au deuxième traitement thermique, tel que décrit en relation avec la figure 4. Ceci transforme les zones 902 en zones 1002 et 1004. Il en résulte une prise de contact constituée, dans cet exemple, de plusieurs zones intermétalliques superposées. Les zones intermétalliques voisines sont en contact l'une avec l'autre. A partir de la région semiconductrice 110, la prise de contact comprend successivement la zone 410 résultant de la réaction d'une partie de la région semiconductrice 110 avec la couche métallique 130 ; et :
- une zone 1002 ayant plus de 70% des atomes non métalliques constitués de silicium ; ou
- plusieurs zones 1002 ayant plus de 70% des atomes non métalliques constitués de silicium, séparées par une ou des zones 1004 ayant leurs atomes non métalliques constitués principalement de germanium.

On remplit ensuite le reste de la cavité de l'ouverture 600 par un conducteur électrique 700, de préférence métallique. La zone 1002 située en partie supérieure de la prise de contact est en contact électrique avec le conducteur 700. Du fait que la zone 902 (figure 9) supérieure n'a pas été altérée lors du retrait des parties n'ayant pas réagi de la couche métallique 130, et du fait qu'il n'y a pas de zone intermétallique provenant de la zone 904A entre la zone 1002 et le conducteur électrique 700, la résistance et la fiabilité du contact entre la prise de contact et le conducteur 700 sont optimisées.

Dans le cas préféré d'un empilement 800 monocristallin, l'ensemble de la prise de contact et la région semiconductrice 110 est monocristallin. De ce fait, la résistance électrique de la prise de contact est inférieure à celle d'une prise de contact non monocristalline. Ceci permet une amélioration supplémentaire de la résistance électrique.

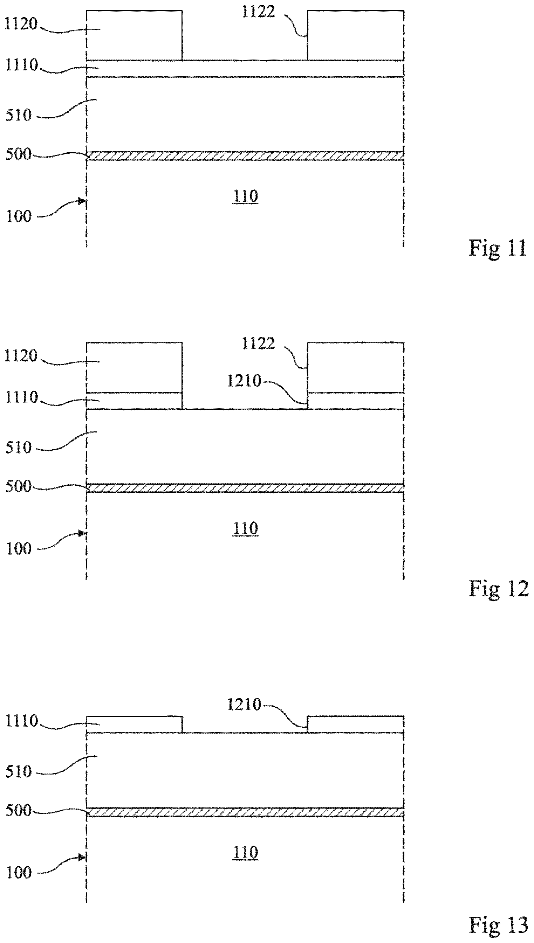

Les figures 11 à 15 sont des vues en coupe, partielles et schématiques, représentant des étapes successives d'un mode de mise en oeuvre, dans l'exemple du deuxième mode de réalisation (figures 5 à 7), d'un procédé de formation d'une ouverture dans la couche isolante recouvrant une région semiconductrice comprenant du germanium. Plus précisément, le procédé est ici appliqué à la formation, à partir de la structure obtenue à l'étape de la figure 5, d'une ouverture 600 (figure 6) dans la couche isolante 510 recouvrant la région semiconductrice 110.

Comme mentionné en relation avec la figure 5, la couche 510 est de préférence en oxyde de silicium, plus préférentiellement en dioxyde de silicium, encore plus préférentiellement résultant d'une hydrolyse de TEOS. Dans une variante, la couche 510 peut également être en un nitrure de silicium.

Dans l'exemple de la structure obtenue à l'étape de la figure 5, comme ceci est mentionné ci-dessus, une couche supplémentaire 500, semiconductrice, est située sous la couche isolante 510. Plus précisément, la couche semiconductrice 500 est située entre la région semiconductrice 110 et la couche isolante 510. La couche semiconductrice 500 est en contact avec la couche isolante 510. La couche 500 est constituée de silicium, ou présente un pourcentage atomique de silicium supérieur à 70 %, la couche 500 étant alors par exemple en silicium-germanium. La couche 500 en silicium en contact avec la couche isolante 510 permet alors d'améliorer la stabilité de la couche isolante 510, par rapport à une structure dépourvue de la couche 500.

A l'étape de la figure 11, on forme une première couche de masquage 1110 sur la couche isolante 510. Par couche de masquage, on entend une couche destinée à être traversée par une ou plusieurs ouvertures traversantes et à être utilisée lors d'une étape de gravure pour laisser passer des réactifs de gravure uniquement par ces ouvertures.

De préférence, la première couche de masquage 1110 est en un matériau diélectrique, c'est-à-dire électriquement isolant. Un avantage est qu'un tel matériau peut être laissé en place sur la couche isolante 510 sans créer de court-circuit entre des futurs éléments conducteurs en contact avec la première couche de masquage 1110. On évite ainsi une étape de retrait de la première couche de masquage 1110.

La première couche de masquage 1110 peut comprendre, par exemple être constituée par, au moins une couche en un matériau choisi dans le groupe constitué de :
- l'oxyde de hafnium HfO₂, de préférence déposé par dépôt de couche atomique ALD (Atomic Layer Deposition) ;
- l'oxyde d'aluminium Al₂O₃, de préférence déposé par ALD ;
- le nitrure d'aliminium AlN, de préférence déposé par dépôt physique en phase vapeur PVD (Physical Vapor Deposition) ;
- l'oxyde de zinc ZnO, de préférence déposé par PVD ; et
- un nitrure de silicium tel que SiN ou Si₃N₄, de préférence déposé par dépôt chimique en phase vapeur CVD (Chemical Vapor Déposition), plus préférentiellement à basse pression LPCVD (Low Pressure CVD), c'est-à-dire dans lequel la pression est sous-atmosphérique.

On forme ensuite, sur la première couche de masquage 1110, une deuxième couche de masquage 1120 comprenant une ouverture 1122. L'ouverture 1122 est située à l'aplomb de l'emplacement de la future ouverture 600. La deuxième couche de masquage 1120 est en polymère, et résulte de préférence de la lithographie d'une résine positive ou négative telle qu'une résine photosensible.

A l'étape de la figure 12, on grave dans la première couche de masquage 1110 une ouverture traversante 1210 située dans le prolongement de l'ouverture 1122 de la deuxième couche de masquage 1120. La gravure s'arrête de préférence sur la surface supérieure de la couche isolante 510. En variante, la gravure s'arrête à un niveau situé dans la couche isolante 510. Ainsi, dans le prolongement de l'ouverture 1210, la couche isolante 510 est laissée en place, sur au moins une partie de son épaisseur, sur la couche semiconductrice 500 et la région semiconductrice 110.

Une éventuelle étape de retrait de résidus de gravure (non représentés), c'est-à-dire une étape de nettoyage, peut être ensuite mise en oeuvre. A titre d'exemple, le nettoyage est réalisé par une solution d'acide fluorhydrique HF.

A l'étape de la figure 13, on retire la deuxième couche de masquage par gravure à base d'oxygène, typiquement par plasma. Par exemple le plasma comprend seulement de l'oxygène ou comprend, outre l'oxygène, du tétrafluorure de carbone CF₄. La température en cours de gravure est typiquement comprise entre 120 et 220°C. Un tel plasma permet de retirer la deuxième couche de masquage 1120 lorsqu'elle résulte d'une lithographie ou de tout procédé de formation d'une couche de masquage comprenant des ouvertures et retirable par gravure à base d'oxygène.

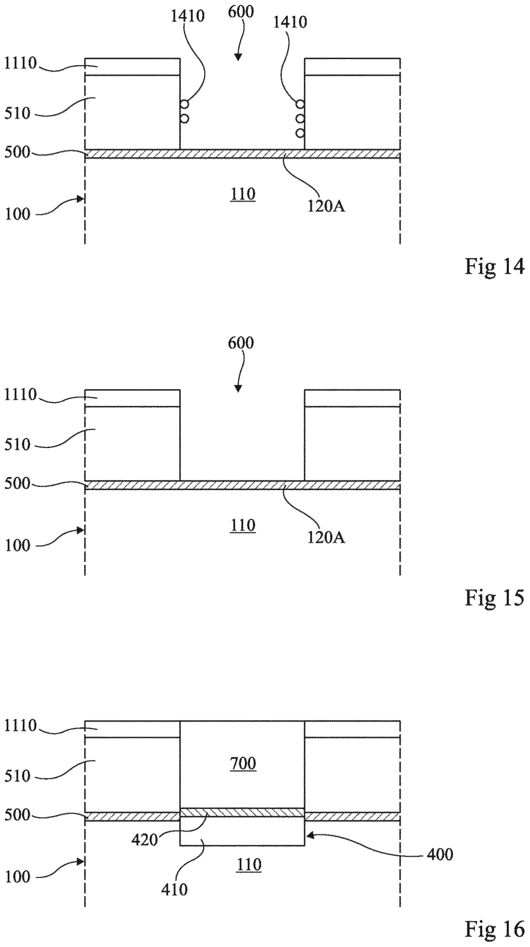

A l'étape de la figure 14, on forme l'ouverture 600 dans le prolongement de l'ouverture 1210 de la première couche de masquage 1110, par gravure à base fluorée, c'est-à-dire une gravure principalement par un ou des réactifs comprenant du fluor. Par principalement, on entend que plus de la moitié, de préférence plus de 90 %, encore plus préférentiellement plus de 99% des molécules réactives utilisées pour la gravure sont fluorées. Plus précisément, la gravure est sensiblement en l'absence d'oxygène, c'est-à-dire que moins de 5 %, de préférence moins de 1 % des molécules réactives utilisées pour la gravure sont de l'oxygène O₂. De préférence, moins de 5 %, plus préférentiellement moins de 1 % des molécules réactives utilisées pour la gravure comprennent de l'oxygène. Plus préférentiellement, le ou les réactifs de gravure sont dépourvus d'oxygène. Dans le présent mode de mise en oeuvre, la gravure est une gravure ionique réactive RIE (Reactive Ion Etching), par exemple par de l'octafluorocyclobutane C₄F₈ et/ou par du trifluorométhane CHF₃.

Le fait, mentionné ci-dessus, que la première couche de masquage 1110 soit dans le groupe constitué de HfO₂, Al₂O₃, AlN, ZnO, SiN, et Si₃N₄ permet de graver sélectivement le matériau de la couche isolante 510 par rapport au matériau de la première couche de masquage 1110. En effet, dans le cas préféré où la couche isolante est en oxyde de silicium résultant d'une hydrolyse de TEOS, la vitesse de gravure de la couche isolante 510 est alors plus de 5 fois plus rapide que la vitesse de gravure du matériau de la couche de masquage. En particulier, selon un mode de réalisation préféré, la première couche de masquage est en HfO₂ ou Al₂O₃, et la vitesse de gravure de l'oxyde de silicium résultant d'une hydrolyse de TEOS est alors plus de 10 fois plus rapide que la vitesse de gravure du matériau de la première couche de masquage.

En pratique, des résidus de gravure 1410 peuvent subsister sur les flancs et le fond de l'ouverture 600. On peut alors prévoir une étape de nettoyage décrite ci-après en relation avec la figure 15.

A l'étape de la figure 15, on retire les résidus de gravure 1410. A titre d'exemple, pour cela, on utilise une solution de HF. La solution a préférentiellement une concentration de HF comprise entre 0,1 % et 1% molaire, et est appliquée pendant une durée comprise entre 10 à 30 s.

On obtient ainsi, à l'issue des étapes des figures 11 à 15, l'ouverture 600 dans la couche isolante 510 recouvrant la région semiconductrice 110. Au lieu de réaliser l'ouverture 600 par les étapes des figures 11 à 15, on pourrait former une seule couche de masquage en polymère directement sur la couche isolante 510, graver l'ouverture 600, puis retirer la couche de masquage par gravure à base d'oxygène. L'épaisseur, mentionnée ci-dessus, de la couche 500 aurait alors été trop faible pour éviter que la couche 500 soit oxydée sur toute son épaisseur, et qu'une partie du germanium de la région semiconductrice 110 soit également oxydé. Il en aurait résulté un prolongement de l'ouverture 600 en dessous du niveau inférieur de la couche isolante 510, tel que mentionné ci-dessus en relation avec les figures 6 et 8.

Par comparaison avec des étapes mettant en oeuvre une seule couche de masquage, les étapes des figures 11 à 15 permettent que la couche isolante 510 protège la couche semiconductrice 500 de l'oxydation au cours du retrait de la couche de masquage en polymère. En particulier, ceci permet de laisser en place une région 120A de la couche semiconductrice 500 au fond de l'ouverture. Ceci permet également de former l'ouverture 600 sans oxyder le germanium de la région semiconductrice 110. On évite ainsi que la région semiconductrice 110 soit endommagée par l'oxydation.

Bien que les étapes des figures 11 à 15 soient ici mises en oeuvre dans l'exemple de la formation de l'ouverture 600 dans la couche isolante 510, des étapes similaires à celles des figures 11 à 15 peuvent être mises en oeuvre pour former toute ouverture dans toute couche isolante recouvrant une région semiconductrice constituée principalement de germanium, la couche isolante étant de préférence en oxyde de silicium et plus préférentiellement en oxyde de silicium résultant d'hydrolyse de TEOS. En particulier, la couche 500 peut être omise. En variante, la couche isolante peut être en nitrure de silicium, l'homme du métier étant alors en mesure de définir le matériau de la première couche de masquage pour obtenir une gravure sélective à base fluorée du nitrure de silicium par rapport à la couche de masquage.

La figure 16 est une vue en coupe, partielle et schématique, représentant un quatrième mode de réalisation d'un procédé de fabrication d'une prise de contact, mettant en oeuvre les étapes des figures 11 à 15.

Après les étapes des figures 11 à 15, on met en oeuvre successivement :
- de la manière décrite en relation avec la figure 6, la formation des couches métallique 130 (figure 6) et éventuellement de protection 140 (figure 6) ; et
- de la manière décrite en relation avec la figure 7, le premier traitement thermique, le retrait de l'éventuelle couche de protection 140 et des portions restantes de la couche métallique 130, le second traitement thermique et le remplissage de l'ouverture 600 par un conducteur électrique 700.

Comme ceci est mentionné ci-dessus, il en résulte, sur la région 110 constituée principalement de germanium et préférentiellement dopée, une prise de contact 400 comprenant une zone intermétallique 420 formée à partir de la région semiconductrice 120A (figure 6). La zone intermétallique résulte de la réaction d'une région 130A (figure 6) de la couche métallique 130 avec la région semiconductrice 120A.

Comme ceci a été mentionné, les étapes des figures 11 à 15 permettent d'éviter que la région semiconductrice 110 soit endommagée par l'oxydation. En outre, la région semiconductrice 110 est préférentiellement dopée. Or, plus le niveau de dopage de la région semiconductrice 110 est élevé, plus cette région est sensible à l'oxydation, ceci plus particulièrement pour un dopage résultant d'une implantation ionique. La prise de contact 400 obtenue a ainsi une résistance plus faible et une fiabilité plus élevée que celles d'une prise de contact pour laquelle l'ouverture 600 a été formée par un procédé à une seule couche de masquage.

La région 120A, qui forme la zone intermétallique 420 par réaction avec la région métallique 130A, est constituée par une partie de la couche semiconductrice 500. Du fait que la couche semiconductrice 500 a un pourcentage atomique de silicium supérieur à 70%, plus de 70 % des atomes non métalliques de la zone intermétallique 420 sont des atomes de silicium. En variante, la région 120A comprend, ou est constituée par, une couche semiconductrice formée sur la portion de couche semiconductrice 500, ou, en l'absence de la couche semiconductrice 500, directement sur la région semiconductrice 110.

Le conducteur électrique 700 est préférentiellement obtenu en formant une couche métallique sur toute la surface supérieure de la structure. On retire ensuite les parties de la couche métallique situées au-dessus du niveau supérieur de la première couche de masquage 1110. Ce retrait est par exemple fait par polissage mécano-chimique. La première couche de masquage 1110 peut alors avantageusement servir de couche d'arrêt.

Bien que, dans les étapes des figures 11 à 16, la première couche de masquage soit en un matériau électriquement isolant pouvant être laissé en place, ceci n'est pas limitatif. En variante, on peut prévoir que la première couche de masquage 1110 soit en un matériau conducteur et soit retirée après formation de l'ouverture 600.

Dans ce cas, selon un mode de réalisation préféré, la première couche de masquage 1110 et la région métallique 130A (figure 6) comprennent, de préférence sont constituées par, un ou des mêmes métaux. Ainsi, la première couche de masquage 1110 peut avantageusement être retirée en même temps que les portions de la couche métallique 130 restantes après la formation de la prise de contact.

Selon un autre mode de réalisation préféré, la première couche de masquage 1110 et la couche de protection 140 (figure 6) recouvrant la région métallique 130A comprennent, de préférence sont constituées par, un ou des mêmes métaux. Ainsi, la première couche de masquage 1110 pourra avantageusement être retirée en même temps que la couche de protection 140.

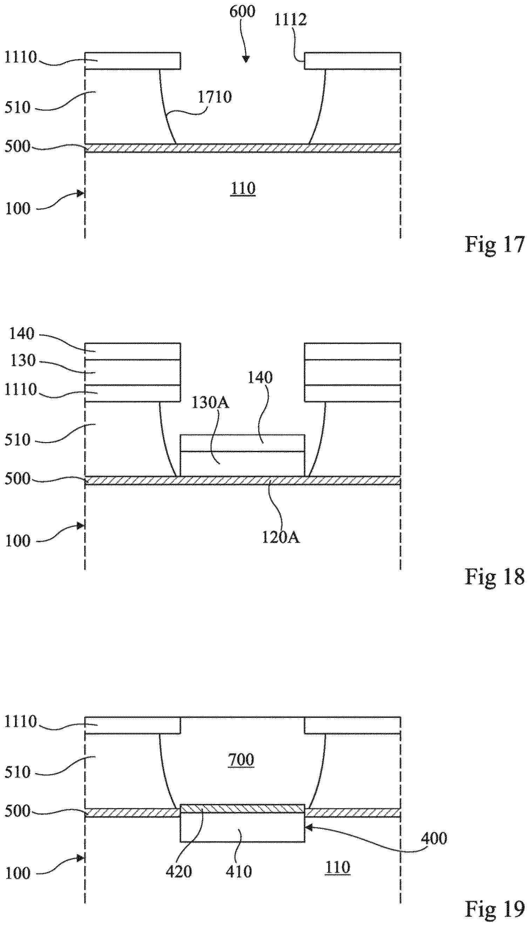

La figure 17 est une vue en coupe, partielle et schématique, représentant une variante de mise en oeuvre du procédé des figures 11 à 15.

La variante de la figure 17 correspond au procédé des figures 11 à 15 dans lequel, à l'étape de la figure 14, la gravure à base fluorée est, au moins en partie, mise en oeuvre par une solution de HF. La solution de HF a préférentiellement une concentration supérieure à celle de la solution HF utilisée à l'étape de nettoyage de la figure 15, par exemple supérieure à 5 % molaire. Une telle gravure est sensiblement isotrope. Il en résulte que l'ouverture 600 dans la couche isolante est plus large que l'ouverture 1112 dans la première couche de masquage 1110. Autrement dit, les flancs 1710 de l'ouverture 600 sont surplombés par les bords de l'ouverture 1112.

Par rapport au cas, mentionné ci-dessus, dans lequel la couche 510 est en nitrure de silicium, le fait de prévoir que la couche 510 soit en oxyde de silicium permet avantageusement que la gravure par plasma à base fluorée soit plus facile et/ou que les formes des flancs et les dimensions de l'ouverture 600 soient mieux contrôlées.

L'étape de la gravure à base fluorée peut être suivie d'une étape de nettoyage correspondant à l'étape de la figure 15.

Les figures 18 et 19 sont des vues en coupe, partielles et schématiques, représentant des étapes d'une variante du quatrième mode de réalisation, mettant en oeuvre la variante de la figure 17.

A l'étape de la figure 18, on forme la couche métallique 130 et, préférentiellement, la couche de protection 140, de la manière décrite en relation avec la figure 6. La couche métallique 130 comprend une région métallique 130A destinée à réagir avec la région semiconductrice 120A pour former une zone intermétallique. Du fait de la forme en surplomb des parois des ouvertures 600 et 1112, la région métallique 130A est avantageusement séparée du reste de la couche 130, ce qui facilite le retrait ultérieur des parties restantes de la couche 130 après réaction.

A l'étape de la figure 19, on forme une prise de contact comprenant des zones intermétalliques 410 et préférentiellement 420, et on remplit l'ouverture 600 d'un conducteur 700, de la manière décrite en relation avec la figure 7.

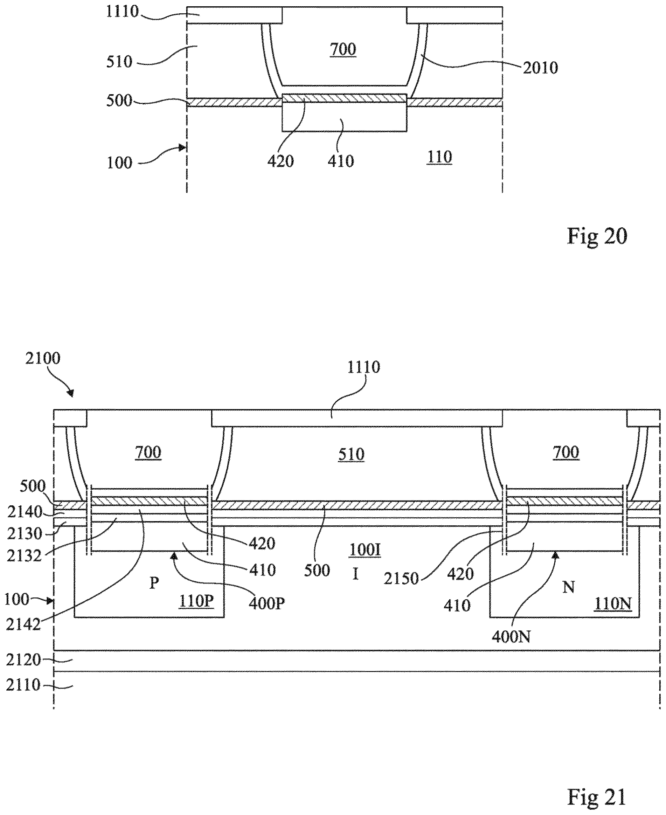

La figure 20 est une vue en coupe, partielle et schématique, représentant un cinquième mode de réalisation d'un procédé de fabrication d'une prise de contact, mettant en oeuvre la variante de la figure 17.

Le cinquième mode de réalisation diffère du deuxième mode de réalisation (figures 5 à 7) en ce que, à l'étape de la figure 7, une couche électriquement conductrice 2010 recouvrant la prise de contact 400 est formée sur le fond et les flancs de l'ouverture 600 avant remplissage de l'ouverture 600 par le conducteur 700.

La couche électriquement conductrice 2010 est préférentiellement en nitrure de titane TiN. La couche électriquement conductrice 2010 est en contact avec la zone intermétallique 420. L'épaisseur de la couche électriquement conductrice 2010 est préférentiellement comprise 5 et 20 nm. La couche électriquement conductrice 2010 permet de protéger la surface supérieure de la prise de contact 420, en particulier contre une diffusion du matériau du conducteur 700 vers la zone intermétallique et/ou contre une oxydation dans le cas où la structure est exposée à l'air avant remplissage de l'ouverture 600 par le conducteur 700. On diminue ainsi la résistance et on augmente la fiabilité de la prise de contact, par rapport à une prise de contact non recouverte de la couche conductrice 2010. La couche 2010, étant électriquement conductrice, permet en outre de réaliser un contact électrique entre la prise de contact le conducteur 700.

La figure 21 est une vue en coupe, partielle et schématique, représentant un mode de réalisation d'une photodiode 2100. Plus précisément, le procédé de fabrication de la photodiode 2100 met ici en oeuvre le cinquième mode de réalisation du procédé de fabrication d'une prise de contact. Le procédé de fabrication de la photodiode est compatible avec les divers modes de réalisation, décrits ci-dessus, de prises de contact.

Pour réaliser la photodiode 2100, on prévoit de préférence que le substrat 100 soit en germanium. Le germanium du substrat 100 est intrinsèque, c'est-à-dire non intentionnellement dopé ou ayant un niveau de dopage inférieur à 10¹⁶ atomes/cm³, de préférence inférieur ou égal à 10¹⁵ atomes/cm³. Le germanium du substrat 100 est, de préférence, monocristallin. En variante, le substrat 100 peut être en silicium-germanium, de préférence intrinsèque et monocristallin.

Le substrat 100 recouvre une tranche semiconductrice 2110 de silicium. Plus précisément, une couche isolante 2120, typiquement en oxyde de silicium, est disposée entre la tranche semiconductrice 2110 et le substrat 100. La tranche semiconductrice 2110, la couche isolante 2120, et le substrat 100 définissent ainsi une structure de type SOI (Semiconductor On Insulator), plus spécifiquement, une structure GeOI (Germanium On Insulator). L'épaisseur de la couche isolante 2120 est typiquement de l'ordre de 0,1 à 1 µm. L'épaisseur totale du substrat 100 est par exemple de l'ordre de 1 à 2 µm.

On forme, dans le substrat 100, une région semiconductrice 110P en germanium dopé de type P, et une région semiconductrice 110N en germanium dopé de type N. Autrement dit, les régions semiconductrices 110N et 110P sont de types de conductivité opposés. Les régions semiconductrices 110N et 110P s'étendent à partir de la face libre, ou accessible, du substrat 100, c'est-à-dire de la face avant (face supérieure dans l'orientation de la figure). Les régions semiconductrices 110N et 110P constituent des régions respectives de cathode et d'anode de la photodiode 2100.

De préférence, les régions semiconductrices 110P et 110N sont obtenues par formation de cavités dans le substrat 100 aux emplacements des régions semiconductrices 110P et 110N, puis remplissage des cavités par épitaxie de germanium dopé. Ceci permet que les régions semiconductrices soient, au moins dans une partie supérieure destinée à la formation des prises de contact, monocristallines. En variante, les régions semiconductrices 110N et 110P sont obtenues par implantation ionique.

Une région semiconductrice 100I du substrat 100 sépare les régions semiconductrices 110P et 110N. La région semiconductrice 100I est ainsi en germanium intrinsèque. A titre d'exemple, la distance séparant les régions semiconductrices 110P et 110N est comprise entre 1 µm et 20 µm.

De préférence, on forme, sur la structure et en particulier sur la région intrinsèque 100I, une couche de silicium-germanium 2130, de préférence monocristalline. La couche de silicium-germanium 2130 est de préférence formée par épitaxie sur le substrat 100, plus précisément sur la face libre du substrat 100. La couche de silicium-germanium 2130 est ainsi en contact avec le substrat 100. La couche de silicium-germanium 2130 a, de préférence, une épaisseur inférieure à l'épaisseur critique en deçà de laquelle la couche de silicium-germanium 2130 reste monocristalline au cours de sa croissance par épitaxie. Ainsi, l'épaisseur de la couche de silicium-germanium 2130 est typiquement inférieure à 3 nm.

De préférence, on forme ensuite la couche semiconductrice 500 sur la couche de silicium-germanium 2130. Plus préférentiellement, avant de former la couche semiconductrice 500, on forme une couche de germanium intrinsèque 2140 sur la couche de silicium-germanium 2130. La couche de germanium 2140 permet en particulier que la couche semiconductrice 500 soit monocristalline. Pour cela, la couche semiconductrice 500 a une épaisseur, mentionnée ci-dessus, suffisamment faible. En effet, en l'absence de la couche de germanium 2140, la somme des épaisseurs de la couche de silicium-germanium 2130 et de la couche semiconductrice 500 serait trop élevée pour que la couche semiconductrice 500 reste monocristalline.

On forme ensuite la couche isolante 510, puis on met en oeuvre, dans l'exemple représenté, le quatrième mode de réalisation (figure 20) du procédé de formation de prise de contact. Plus précisément, le procédé est mis en oeuvre pour former simultanément deux prises de contact 400N et 400P avec les régions semiconductrices respectives 110N et 110P. Chaque prise de contact 400N, 400P comprend ainsi une zone intermétallique 420, dans laquelle plus de 70 % des atomes non métalliques sont des atomes silicium, et, préférentiellement, une zone intermétallique 410, dans laquelle les atomes non métalliques sont principalement des atomes de germanium. Les bords des prises de contact ne sont pas représentés (régions entre pointillés 2150). Dans le cas où la couche de silicium-germanium 2130 est prévue, la prise de contact peut comprendre, en outre, une zone intermétallique 2132 située sur et en contact avec la zone intermétallique 410. La zone intermétallique 2132 comprend des atomes de silicium et des atomes de germanium. Dans le cas où la couche de germanium 2140 est prévue, la prise de contact peut comprendre, en outre, une zone intermétallique 2142, dans laquelle les atomes non métalliques sont principalement, de préférence sont seulement, des atomes de germanium. La zone intermétallique 2142 est comprise entre les zones 2132 et 420.

Dans la photodiode 2100 ainsi obtenue, la couche de silicium-germanium 2130, située entre la région semiconductrice 110I et la couche isolante 510, est en contact avec la région intrinsèque 100I. Ceci permet d'obtenir une interface monocristalline délimitant la région semiconductrice 110I. Une telle interface permet de réduire le courant d'obscurité de la photodiode, par rapport à une interface présentant des défauts cristallins. En outre, la couche de germanium 2140 est située entre la couche de silicium-germanium 2130 et la couche isolante 510, de préférence entre couche de silicium-germanium 2130 et la couche semiconductrice 500. Du fait que le silicium-germanium a une bande interdite (band gap) plus large que celle du germanium, des porteurs présents dans la couche de germanium 2140 ne peuvent accéder à la région intrinsèque 110I. Ces porteurs peuvent par exemple provenir de défauts à l'interface de la couche semiconductrice 500 avec la couche isolante 510 et/ou la couche de germanium 2140. Du fait que les couches 2130 et 2140 permettent d'empêcher ces porteurs d'atteindre la région intrinsèque 100I, le courant d'obscurité de la photodiode est réduit par rapport au courant d'obscurité d'une photodiode dépourvue des couches 2130 et/ou 2140.

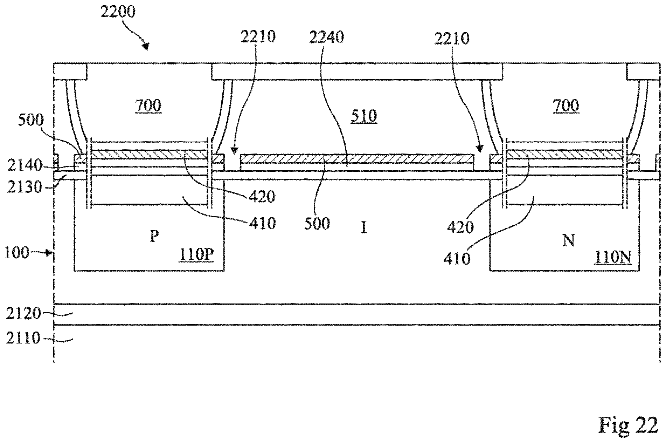

La figure 22 est une vue en coupe, partielle et schématique, représentant un autre mode de réalisation d'une photodiode 2200. Le procédé de fabrication de la photodiode 2200 diffère de celui de la photodiode 2100 de la figure 21 en ce que, avant formation de la couche isolante 510, on a formé des tranchées isolantes 2210 délimitant, sur la région intrinsèque 100I, une portion 2240 de la couche de germanium 2140. De préférence, les tranchées isolantes 2210 sont situées à l'aplomb des bords de la région intrinsèque 100I. Les tranchées isolantes sont ensuite remplies d'un isolant électrique, de préférence l'isolant de la couche 510.

A titre d'exemple, les tranchées 2210 ont une largeur comprise entre 100 nm et 300 nm. Dans l'exemple représenté, les tranchées s'étendent à partir de la face supérieure de la couche semiconductrice 500, à travers les couches 500 et 2140, jusqu'à la face supérieure de la couche de silicium-germanium 2130. En variante, les tranchées 2210 se prolongent à travers la couche 2130, par exemple au moins jusqu'à la face supérieure du substrat 100.

Les tranchées 2210 constituent ainsi des zones isolantes délimitant une portion de la couche de germanium 2140 sur la région intrinsèque 100I. Ces zones isolantes sont situées entre la couche de germanium 2140 et les prises de contact 400N et 400P. La photodiode 2200 est compatible avec tout procédé de formation d'une couche de germanium intrinsèque située sur la région intrinsèque 100I et délimitée par des zones isolantes situées entre ladite couche de germanium 2140 et les prises de contact. Ainsi, en variante, la couche de germanium 2140 peut être formée uniquement sur la région intrinsèque 100I.

Les zones isolantes 2210 permettent d'éviter que des porteurs présents dans la couche de germanium 2140, mentionnés ci-dessus, parviennent aux prises de contact 400N et 400P. Ainsi, les zones isolantes permettent à la photodiode 2200 de présenter un courant d'obscurité plus faible que celui d'une photodiode, telle que la photodiode 2100 de la figure 21, dépourvue des zones isolantes 2210.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, les modes de réalisation de procédés de formation de prises de contact comprenant une étape de formation d'ouverture sont compatibles avec les étapes de formation d'ouverture des figures 11 à 15 et sont compatibles avec les étapes de formation d'ouverture des figures 17 et 18.

Enfin, la mise en oeuvre pratique des modes de réalisation et variantes décrits est à la portée de l'homme du métier à partir des indications fonctionnelles données ci-dessus.

## Revendications

1. Procédé de formation d'une ouverture (600) dans une couche isolante (510) recouvrant une région semiconductrice (110 ; 110N, 110P) comportant du germanium, comprenant successivement :
a) la formation d'une première couche de masquage (1110) sur la couche isolante (510) ;
b) la formation sur la première couche de masquage (1110) d'une deuxième couche de masquage (1120) comprenant une ouverture (1122) ;
c) la gravure d'une ouverture (1210) dans la première couche de masquage, dans le prolongement de l'ouverture de la deuxième couche de masquage ;
d) le retrait de la deuxième couche de masquage (1120) par gravure à base d'oxygène ; et
e) la formation de l'ouverture (600) de ladite couche isolante (510) dans le prolongement de l'ouverture de la première couche de masquage, par une gravure dans laquelle moins de 5 % des molécules réactives utilisées sont des molécules d'oxygène,
dans lequel :
I) la couche isolante (510) est disposée sur et en contact avec la face supérieure de ladite région semiconductrice (110 ; 110N, 110P) ; ou
II) la couche isolante (510) est disposée sur et en contact avec une couche semiconductrice supplémentaire (500), ladite couche semiconductrice supplémentaire (500) étant en silicium ou ayant un pourcentage atomique de silicium supérieur à 70%, et recouvrant ladite région semiconductrice (110 ; 110N, 110P).

2. Procédé selon la revendication 1, dans lequel la couche isolante (510) est en oxyde de silicium.

3. Procédé selon la revendication 1 ou 2, dans lequel la première couche de masquage (1110) est en un matériau électriquement isolant, de préférence dans le groupe constitué de HfO₂, Al₂O₃, AlN, ZnO, SiN, et Si₃N₄.

4. Procédé selon l'une quelconque des revendications 1 à 3, dans lequel l'étape e) comprend une gravure par plasma à base de C₄F₈ et/ou CHF₃, et/ou par une solution d'HF.

5. Procédé selon l'une quelconque des revendications 1 à 4, dans lequel la deuxième couche de masquage (1120) est une couche de polymère résultant d'une lithographie.

6. Procédé de formation d'une prise de contact (400), comprenant la mise en oeuvre d'un procédé selon l'une quelconque des revendications 1 à 5, la prise de contact étant une prise de contact avec ladite région semiconductrice (110) et comprenant une zone intermétallique (420) dans laquelle plus de 70 % des atomes non métalliques sont de silicium.

7. Procédé selon la revendication 6, dans lequel la formation de ladite zone intermétallique (420) comprend la réaction d'un semiconducteur avec une région métallique (130A), la première couche de masquage (1110) et la région métallique (130A) comprenant un même métal.

8. Procédé selon la revendication 6, dans lequel la formation de la zone intermétallique (420) comprend la réaction d'un semiconducteur avec une région métallique (130A) recouverte d'une couche de protection (140), la première couche de masquage (1110) et la couche de protection (140) comprenant un même métal.

9. Procédé selon l'une quelconque des revendications 6 à 8, comprenant en outre la formation d'une couche électriquement conductrice (2010) recouvrant la prise de contact (400) et les parois de l'ouverture (600), et le remplissage de l'ouverture par un conducteur (700) recouvrant ladite couche électriquement conductrice (2010) .

10. Procédé de formation d'une photodiode comprenant la formation, par un procédé selon l'une quelconque des revendications 6 à 9, de première (400N) et deuxième (400P) prises de contact respectives avec des première (110N) et deuxième (110P) régions semiconductrices comprenant du germanium, les première et deuxième régions semiconductrices étant dopées de types de conductivité opposés et séparées par une troisième région semiconductrice (100I) comprenant du germanium intrinsèque.

11. Procédé selon la revendication 10, dans lequel une couche de silicium-germanium (2130) est située entre la troisième région (100I) et ladite couche isolante (510) et est en contact avec la troisième région (100I).

12. Procédé selon la revendication 11, dans lequel une couche de germanium intrinsèque (2140) est située entre ladite couche de silicium-germanium et ladite couche isolante (510) .

13. Procédé selon la revendication 12, comprenant la formation de zones isolantes (2210) délimitant ladite couche de germanium intrinsèque (2140) et situées entre ladite couche de germanium intrinsèque et les première (400N) et deuxième (400P) prises de contact.

## Patentansprüche

1. Verfahren zum Ausbilden einer Öffnung (600) in einer Isolierschicht (510), die einen Germanium aufweisenden Halbleiterbereich (110; 110N, 110P) bedeckt, das nacheinander folgende Schritte aufweist:
a) Ausbilden einer ersten Maskenschicht (1110) auf der Isolierschicht (510);
b) Ausbilden einer zweiten Maskenschicht (1120) mit einer Öffnung (1122) auf der ersten Maskenschicht (1110);
c) Ätzen einer Öffnung (1210) in der ersten Maskenschicht, die mit der Öffnung der zweiten Maskenschicht übereinstimmt;
d) Entfernung der zweiten Maskenschicht (1120) durch Ätzen auf Sauerstoffbasis; und
e) Ausbilden der Öffnung (600) der Isolierschicht (510) in Übereinstimmung mit der Öffnung der ersten Maskenschicht durch ein Ätzen, bei dem weniger als 5% der verwendeten reaktiven Moleküle Sauerstoffmoleküle sind,
wobei:
I) die Isolierschicht (510) auf der oberen Fläche des Halbleiterbereichs (110; 110N, 110P) angeordnet ist und mit dieser in Kontakt steht; oder
II) die Isolierschicht (510) sich auf einer zusätzlichen Halbleiterschicht (500) befindet und mit dieser in Kontakt steht, wobei die zusätzliche Halbleiterschicht (500) aus Silizium besteht oder einen Atomprozentsatz an Silizium von mehr als 70% aufweist und den Halbleiterbereich (110; 110N, 110P) bedeckt.

2. Verfahren nach Anspruch 1, wobei die Isolierschicht (510) aus Siliziumoxid besteht.

3. Verfahren nach Anspruch 1 oder 2, wobei die erste Maskenschicht (1110) aus einem elektrisch isolierenden Material besteht, vorzugsweise aus der Gruppe gebildet aus HfO₂, Al₂O₃, AlN, ZnO, SiN und Si₃N₄.

4. Verfahren nach einem der Ansprüche 1 bis 3, wobei Schritt e) ein Ätzen mit einem Plasma auf der Basis von C₄F₈ und/oder CHF₃ und/oder mit einer HF-Lösung aufweist.

5. Verfahren nach einem der Ansprüche 1 bis 4, wobei die zweite Maskierungsschicht (1120) eine lithographisch hergestellte Polymerschicht ist.

6. Verfahren zum Ausbilden eines Kontaktbereichs (400), das die Durchführung des Verfahrens nach einem der Ansprüche 1 bis 5 aufweist, wobei der Kontaktbereich ein Kontaktbereich mit einem gleichen Halbleiterbereich (110) ist und einen intermetallischen Bereich (420) aufweist, bei dem mehr als 70 % der Nichtmetallatome Silizium sind.

7. Verfahren nach Anspruch 6, wobei das Ausbilden des intermetallischen Bereichs (420) die Reaktion eines Halbleiters mit einem Metallbereich (130A) aufweist, wobei die erste Maskenschicht (1110) und der Metallbereich (130A) dasselbe Metall aufweisen.

8. Verfahren nach Anspruch 6, wobei das Ausbilden des intermetallischen Bereichs (420) die Reaktion eines Halbleiters mit einem Metallbereich (130A) aufweist, der mit einer Schutzschicht (140) bedeckt ist, wobei die erste Maskenschicht (1110) und die Schutzschicht (140) dasselbe Metall aufweisen.

9. Verfahren nach einem der Ansprüche 6 bis 8, das ferner Folgendes aufweist: das Ausbilden einer elektrisch leitenden Schicht (2010), die den Kontaktbereich (400) und die Wände der Öffnung (600) bedeckt, und das Füllen der Öffnung mit einem Leiter (700), der die elektrisch leitende Schicht (2010) bedeckt.

10. Verfahren zum Ausbilden einer Photodiode, aufweisend das Ausbilden durch das Verfahren nach einem der Ansprüche 6 bis 9 eines jeweiligen ersten (400N) und zweiten (400P) Kontaktbereichs mit ersten (110N) und zweiten (110P) Halbleiterbereiches, die Germanium enthalten, wobei die ersten und zweiten Halbleiterbereiche mit entgegengesetzten Leitfähigkeitstypen dotiert und durch einen dritten Halbleiterbereich (100I) getrennt sind, der intrinsisches Germanium aufweist.

11. Verfahren nach Anspruch 10, wobei eine Silizium-GermaniumSchicht (2130) zwischen dem dritten Bereich (100I) und der Isolierschicht (510) angeordnet ist und in Kontakt mit dem dritten Bereich (100I) steht.

12. Verfahren nach Anspruch 11, wobei eine intrinsische Germaniumschicht (2140) zwischen der Silizium-GermaniumSchicht und der Isolierschicht (510) angeordnet ist.

13. Verfahren nach Anspruch 12, das das Ausbilden von Isolierbereichen (2210) aufweist, die die intrinsische Germaniumschicht (2140) begrenzt und zwischen der intrinsischen Germaniumschicht und den ersten (400N) und zweiten (400P) Kontaktbereichen angeordnet ist.

## Claims

1. A method of forming an opening (600) in an insulating layer (510) covering a semiconductor region (110; 110N, 110P) comprising germanium, successively comprising:
a) the forming of a first masking layer (1110) on the insulating layer (510);
b) the forming on the first masking layer (1110) of a second masking layer (1120) comprising an opening (1122) ;
c) the etching an opening (1210) in the first masking layer, in line with the opening of the second masking layer;
d) the removal of the second masking layer (1120) by oxygen-based etching; and
e) the forming of the opening (600) of said insulating layer (510) in line with the opening of the first masking layer, by an etching where less than 5% of the reactive molecules used are oxygen molecules,
wherein:
I) the insulating layer (510) is located on and in contact with the upper surface of said semiconductor region (110 ; 110N, 110P); or
II) the insulating layer (510) is located on an in contact with an additional semiconductor layer (500), said additional semiconductor layer (500) being made of silicon or having an atomic percentage of silicon greater than 70%, and covering said semiconductor region (110 ; 110N, 110P).

2. The method according to claim 1, wherein the insulating layer (510) is made of silicon oxide.

3. The method according to claim 1 or 2, wherein the first masking layer (1110) is made of an electrically-insulating material, preferably from the group formed of HfO₂, Al₂O₃, AlN, ZnO, SiN, and Si₃N₄.

4. The method according to any of claims 1 to 3, wherein step e) comprises an etching with a plasma based on C₄F₈ and/or CHF₃, and/or with an HF solution.

5. The method according to any of claims 1 to 4, wherein the second masking layer (1120) is a polymer layer resulting from a lithography.

6. A method of forming a contacting area (400), comprising the implementation of the method according to any of claims 1 to 5, the contacting area being an area of contact with a same semiconductor region (110) and comprising an intermetallic area (420) where more than 70% of the non-metal atoms are silicon.

7. The method according to claim 6, wherein the forming of said intermetallic area (420) comprises reacting a semiconductor with a metal region (130A), the first masking layer (1110) and the metal region (130A) comprising a same metal.

8. The method according to claim 6, wherein the forming of the intermetallic area (420) comprises reacting a semiconductor with a metal region (130A) covered with a protection layer (140), the first masking layer (1110) and the protection layer (140) comprising a same metal.

9. The method according to any of claims 6 to 8, further comprising the forming of an electrically-conductive layer (2010) covering the contacting area (400) and the walls of the opening (600) and the filling of the opening with a conductor (700) covering said electrically-conductive layer (2010).

10. A method of forming a photodiode comprising the forming, by the method according to any of claims 6 to 9, of first (400N) and second (400P) respective areas of contact with first (110N) and second (110P) semiconductor regions comprising germanium, the first and second semiconductor regions being doped with opposite conductivity types and separated by a third semiconductor region (100I) comprising intrinsic germanium.

11. The method according to claim 10, wherein a silicon-germanium layer (2130) is located between the third region (100I) and said insulating layer (510) and is in contact with the third region (1001).

12. The method according to claim 11, wherein an intrinsic germanium layer (2140) is located between said silicon-germanium layer and said insulating layer (510).

13. The method according to claim 12, comprising the forming of insulating areas (2210) delimiting said intrinsic germanium layer (2140) and located between said intrinsic germanium layer and the first (400N) and second (400P) contacting areas.
